# EUROPÄISCHE PATENTSCHRIFT

(11) **EP 0 740 348 B1**
(45) Veröffentlichungstag und Bekanntmachung des Hinweises auf die Patenterteilung: **27.02.2002**
(21) Anmeldenummer: 95106101.9
(22) Anmeldetag: 24.04.1995
(51) Int. Cl.: H01L 27/115, H01L 27/108, H01L 21/8239, H01L 29/92

(54) **Halbleiter-Speichervorrichtung unter Verwendung eines ferroelektrischen Dielektrikums und Verfahren zur Herstellung**
Semiconductor memory structure, using a ferroelectric dielectric and method of formation
Structure de mémoire à semi-conducteurs utilisant un diélectrique ferroélectrique et méthode de fabrication

(43) Veröffentlichungstag der Anmeldung: 30.10.1996
(73) Patentinhaber: Infineon Technologies AG, 81669 München (DE)
(72) Erfinder: Widmann, Dietrich, Dr. Ing., D-82008 Unterhaching (DE); Tempel, Georg, Dr. rer. nat., D-81927 München (DE)
(74) Vertreter: Zimmermann & Partner

(56) Entgegenhaltungen:
- EP-A- 0 503 078
- DE-A- 3 922 456
- DE-A- 4 107 165
- US-A- 5 262 343
- MICROELECTRONIC ENGINEERING, Bd. 22, Nr. 1 / 04, 1.August 1993 Seiten 53-60, XP 000385135 LARSEN P K ET AL 'FERROELECTRICS AND HIGH PERMITTIVITY DIELECTRICS FOR MEMORY APPLICATIONS'
- 1994 SYMPOSIUM ON VLSI TECHNOLOGY, DIGEST OF TECHNICAL PAPERS, 7.Juni 1994 - 9.Juni 1994 HONOLULU, Seiten 55-56, R. MOAZZAMI ET AL. 'Integration of ferroelectric capacitor technology with CMOS'
- IEICE TRANSACTIONS ON ELECTRONICS, Bd. E75-C, Nr. 11, 1.November 1992 Seiten 1313-1321, XP 000336333 KAZUHIKO SAGARA ET AL 'RECESSED MEMORY ARRAY TECHNOLOGY FOR A DOUBLE CYLINDRICAL STACKED CAPACITOR CELL OF 256M DRAM'

## Beschreibung

Die Erfindung bezieht sich auf ein Verfahren zur Herstellung eines Kondensators und auf eine Halbleiter-Speichervorrichtung mit einer Vielzahl von auf einem Halbleitersubstrat angeordneten Speicherzellen, von denen jede einen in einem Halbleitersubstrat angeordneten und jeweils einen Gateanschluß sowie einen ersten und einen zweiten Elektrodenanschluß aufweisenden Auswahltransistor und einen dem Auswahltransistor zugeordneten und vermittels diesem ansteuerbaren Speicherkondensator mit einem ferroelektrischen Dielektrikum sowie einer ersten und einer zweiten Kondensatorelektrode aufweist, wobei jeder Gateanschluß des Auswahltransistors mit einer Wortleitung der Halbleiter-Speichervorrichtung, jeder erste Elektrodenanschluß des Auswahltransistors mit einer Bitleitung, und jede erste Kondensatorelektrode des Speicherkondensators mit einer gemeinsamen Leiterschicht aus elektrisch leitendem Material verbunden ist, sowie auf ein Verfahren zur Herstellung einer solchen Halbleiter-Speichervorrichtung.

Eine derartige Halbleiter-Speichervorrichtung mit einem Speicherkondensator mit einem ferroelektrischen Dielektrikum (sogenannter FRAM) ist beispielsweise aus R. Moazzami et al, Symposium on VLSI Technology Digest of Technical Papers 1994, Seiten 55 ff., und Tatsumi Sumi et al., IEEE International Solid-State Circuits Conference 1994, Seiten 268 ff. bekannt, bei welcher Halbleiter-Speichervorrichtung die Speicherkondensatoren mit dem ferroelektrischen Dielektrikum planar ausgebildet sind und auch aufgrund der Verdrahtung erhebliche Zellflächen pro Bit aufweisen, was angesichts einer erwünschten hohen Integrationsdichte als nachteilig angesehen wird. Trotz der bislang noch bestehenden Probleme wird den ferroelektrischen Speichern bzw. FRAMs eine große Zukunft vorausgesagt. Sie könnten die gegenwärtigen Halbleiter-Speicher (DRAM, SRAM, EEPROM, Flash EEPROM) vollständig verdrängen. Die Vorteile von FRAMs liegen vor allem in der kurzen Programmierzeit (> 20 ns), in einer niedrigen Programmierspannung (ab etwa 3 V Speisespannung der ICs), einem niedrigen Energieverbrauch beim Programmieren (keine Ladungspumpe erforderlich), sowie einer häufigen Programmierbarkeit (10¹² nachgewiesen, 10¹⁵ erwartet, gegenüber 10⁵ bei EEPROMs). Insbesondere zum heutigen Zeitpunkt aussichtsreich erscheinende Materialen für die ferroelektrische Schicht sind beispielsweise Blei-Zirkonium-Titanat, Strontium-Tantalat oder Verbindungen hiervon. Eines der Probleme, die einer raschen Einführung der FRAM-Technologie noch im Wege stehen, ist die noch nicht gelöste Kompatibilität mit einem Herstellprozeß für Integrierte Schaltungen. Insbesondere die Notwendigkeit von Platin-Elektroden an der ferroelektrischen Speicherkapazität und der bis zum jetzigen Zeitpunkt üblichen Schleudertechnik für das Aufbringen des ferroelektrischen Gels, die verbunden ist mit einer relativ großen Schichtdicke und damit flächenintensiven Kapazität, verhinderten bis heute einen vertretbaren Einsatz in der Halbleitertechnologie, so daß bislang kein serientauglicher Prozeß für die Herstellung von FRAMs bekannt ist. Hierbei ist auch zu berücksichtigen, daß die Abscheidung der relativ komplexen Materialen für das ferroelektrische Dielektrikum und damit verbunden das Problem einer zufriedenstellenden und prozeßtauglichen Quelle, darüber hinaus eine mangelnde Qualität der Schichten aufgrund von Rißbildung, Leckströmen, Temperatureinflüssen sowie Elektrodenhaftung zu den Problemen einer Prozeß-Integration beiträgt. Hierbei reagieren insbesondere die bisher bekannten ferroelektrischen Materialien äußerst empfindlich auf Wasserstoff, welcher sich aber kaum in den bekannten Verfahren zur Herstellung einer Halbleiter-Speichervorrichtung unterdrücken läßt, und dort insbesondere bei Plasmaabscheidungsprozessen und Plasmaätzprozessen vorkommt.

Neben diesen FRAM-Zellen sind hochintegrierte DRAM-Halbleiterspeicher mit herkömmlichen Materialien für das Dielektrikum des Speicherkondensators bekannt. Hierbei werden zur Realisierung von DRAM-Halbleiterspeicher mit einer Speicherkapazität von derzeit bis etwa 256 Megabyte Dielektrika mit einer hohen dielektrischen Konstante eingesetzt, um bei geringer werdener Zellfläche trotzdem eine ausreichende Kapazität, typischerweise von mehr als etwa 20 fF pro Zelle zu erreichen. Für diese Zwecke wird bis heute in den meisten Fällen eine ONO-Schicht eingesetzt, bei der mittlerweile die technologischen Grenzen erkennbar sind, da der Leckstrom über den vorgegebenen Grenzwert bei einer weiteren Reduktion der Dicke ansteigt, und ausreichende Kapazitäten (Flächen) nur noch mittels aufwendiger Strukturen wie Trench- oder Stacked-Kondensatoren erhalten werden können. Aus diesen Gründen werden in zunehmenden Maße für das Dielektrikum des Speicherkondensators neue Materialien mit ausreichend hoher dielektrischen Konstante eingesetzt; allerdings sind die bislang bekannten alternativen dielektrischen Materialien äußerst empfindlich auf die im bisher verwendeten Verfahren zur Herstellung einer Halbleiter-Speichervorrichtung auftretenden üblichen Belastungen, namentlich Stabilität gegen hohe Prozeßtemperaturen, unerwünschte chemische Reaktionen und dergleichen.

Aus der EP-A-0 503 078 ist eine FRAM-Halbleiterspeicherzelle mit einem planar ausgebildeten Speicherkondensator mit ferroelektrischem Dielektrikum, unterer Kondensatorelektrode, sowie oberer Kondensatorelektrode bekannt.

Aus der DE-A-3 922 456 ist eine herkömmliche DRAM-Halbleiterspeichereinrichtung mit einer geschichteten Kondensatorzelle bekannt.

Aus IEICE Trans. Electron., Bd. E75-C, Nr. 11 (1992) S. 1313-1321 ist eine 256M DRAM-Halbleiterspeichervorrichtung mit einer RSTC-Anordnung ("Recessed Stacked Capacitor") des Speicherkondensators bekannt.

Ausgehend von diesem Stand der Technik liegt der Erfindung die Aufgabe zugrunde, ein Verfahren zur Herstellung eines Kondensators sowie eine Halbleiter-Speichervorrichtung mit einem Speicherkondensator anzugeben, die eine zu den bisherigen Halbleiter-Speichervorrichtung annähernd vergleichbare Integrationsdichte bei entsprechend hoher Zuverlässigkeit und Qualität besitzt und mit vergleichsweise geringem Aufwand in bestehende Prozeßabläufe integriert werden kann, dabei serientauglich ist, d.h. eine hohe Ausbeute der gefertigten Halbleiter-Speichervorrichtungen mit Speicherkondensator bei geringstmöglicher Anzahl von Frühausfällen ermöglicht.

Diese Aufgabe wird erfindungsgemäß durch ein Verfahren zur Herstellung eines Kondensators gemäß Anspruch 1 sowie durch eine Halbleiter-Speichervorrichtung gemäß Anspruch 8 gelöst.

Das erfindungsgemäße Verfahren zur Herstellung eines Kondensators mit einem Dielektrikum sowie einer ersten und zweiten Kondensatorelektrode in einer auf einem Halbleitersubstrat gebildeten Halbleiter-Speichervorrichtung zeichnet sich durch folgende Schritte aus:
a) ganzflächiges Aufbringen einer isolierenden Deckschicht auf das Halbleitersubstrat,
b) Ausbilden eines Grabens in einer auf die isolierende Deckschicht aufgetragenen Kontaktmetallisierungsschicht, wobei der Graben zumindest bis zur isolierenden Deckschicht reicht,
c) zu den Seitenwänden des Grabens wenigstens bereichsweises konformes Abscheiden einer elektrisch leitenden Schicht für die zweite Kondensatorelektrode innerhalb des Grabens,
d) anisotropes Rückätzen der elektrisch leitenden Schicht unter Bildung von Spacern an den Seitenwänden des Grabens,
e) konformes Abscheiden einer als Platzhalter für das Dielektrikum dienenden isolierenden Hilfsschicht innerhalb des Grabens auf die elektrisch leitende Schicht für die zweite Kondensatorelektrode,
f) konformes Abscheiden einer elektrisch leitenden Schicht für die erste Kondensatorelektrode innerhalb des Grabens auf die Hilfsschicht,
g) teilweises Entfernen der Hilfsschicht und dadurch Freilegen einer Hohlschicht in wenigstens einem Teilbereich zwischen den beiden elektrisch leitenden Schichten für die erste und die zweite Kondensatorelektrode,
h) Abscheiden des Dielektrikums in die freigelegte Hohlschicht zwischen den beiden elektrisch leitenden Schichten für die erste und die zweite Kondensatorelektrode.

Vorzugsweise wird der Schritt des Abscheidens der dielektrischen Schicht mittels Aufschleudern durchgeführt. Dem Prinzip der Erfindung folgend können somit dielektrische Schichten in einer Schichtdicke im Nanometerbereich aufgetragen werden, die aufgrund ihrer zähflüssen, lackartigen Konsistenz vorzugsweise im Schleuderverfahren aufgetragen werden können. Hierbei wird durch Aufschleudern das Dielektrikum, wobei das Material des Dielektrikums vorzugsweise als in einem Lösungsmittel eingebrachte Substanz vorliegt, in die freigelegte Hohlschicht zwischen den beiden elektrisch leitendenden Schichten für die erste und zweite Kondensatorelektrode abgeschieden.

Bei einer bevorzugten Ausführung der Erfindung stellt das Dielektrikum ein Ferroelektrisches Gel dar, welches durch Aufschleudern aufgetragen wird. Darüber hinaus kann das Dielektrikum auch eine andere, nicht notwendigerweise ferroelektrische Substanz darstellen, die im Schleuderverfahren aufzutragen ist, namentlich eine solche Substanz für das Dielektrikum mit einer gegenüber den vorbekannten Substanzen größeren Dielektrizitätskonstante.

Erfindungsgemäß ist ferner eine Halbleiter-Speichervorrichtung der gattungsgemäßen Art vorgesehen, bei welcher der dem Auswahltransistor zugeordnete Speicherkondensator mit dem ferroelektrischen Dielektrikum eine gegenüber der Ebene der Substratoberfläche aufragende Anordnung besitzt. Hierbei ist der Speicherkondensator mit dem ferroelektrischen Dielektrikum in einem innerhalb der ohnehin vorhandenen Kontaktmetallisierungsschicht für den zweiten Elektrodenanschluß des Auswahltransistors ausgebildeten Grabens angeordnet, wobei die Tiefe des Grabens der Schichtdicke der Kontaktmetallisierungsschicht entspricht. Diese Ausbildung des Speicherkondensators mit dem ferroelektrischen Dielektrikum in einer aufragenden Anordnung ermöglicht es, bei kleinstmöglicher Fläche der FRAM-Zelle trotzdem eine ausreichende Kapazität des Speicherkondensators zu erreichen, wobei die erfindungsgemäße Ausbildung mit einer gegenüber der Ebene der Substratoberfläche aufragenden Anordnung des ferroelektrischen Speicherkondensators die Ausbildung des hinsichtlich der gewünschten hohen Integrationsdichte kritischer anzusehenden Ferroelektrikums nach einer vollständigen Fertigung der diesbezüglich weniger kritischen Bestandteile der Speicherzelle, d.h. Auswahltransistoren mit vollständiger Metallisierung einschließlich zugehörenden Elektroden, ermöglicht wird, vorzugsweise dadurch, daß das vermittels Schleudertechnik aufzubringende ferroelektrische Gel innerhalb einer zwischen den beiden Kondensatorelektroden ausgebildeten dünnen Hohlschicht eingebracht ist, wobei die Hohlschicht ebenfalls eine gegenüber der Ebene der Substratoberfläche aufragende Anordnung besitzt.

Dem Prinzip der Erfindung folgend ist vorgesehen, daß die gegenüber der Ebene der Substratoberfläche aufragende Anordnung des Speicherkondensators mit dem ferroelektrischen Dielektrikum im wesentlichen zylindersymmetrisch ausgebildet ist mit einer wenigstens annähernd senkrecht zur Ebene der Substratoberfläche verlaufenden Zylindermittenachse.

Die zweite Kondensatorelektrode des innerhalb des Grabens ausgebildeten Speicherkondensators kann als konform auf den senkrechten Seitenwänden des Grabens abgeschiedener Metallspacer ausgebildet sein.

Bei einer weiterhin bevorzugten Ausgestaltung ist vorgesehen, daß die erste Kondensatorelektrode des Speicherkondensators einen innerhalb des Grabens ausgebildeten, koaxial zur Längserstreckung des Grabens und gegenüberliegend zur zweiten Kondensatorelektrode verlaufenden Elektrodenabschnitt aufweist, und das ferroelektrische Dielektrikum zumindest zwischen dem Elektrodenabschnitt der ersten Kondensatorelektrode und der zweiten Kondensatorelektrode angeordnet ist. Dabei kann die erste Kondensatorelektrode des Speicherkondensators becherförmig innerhalb der zweiten Kondensatorelektrode ausgebildet sein.

Das erfindungsgemäße Verfahren sieht vor, den dem Auswahltransistor zugeordneten Speicherkondensator mit dem ferroelektrischen Dielektrikum nach Fertigstellung des Auswahltransistors und seiner zugehörigen Metallisierungsschichten für den Anschluß der Wort- und Bitleitungen in einer gegenüber der Ebene des zur Oberfläche des Halbleitersubstrates im wesentlichen parallel angeordneten Auswahltransistors aufragenden Anordnung herzustellen. Hierbei wird der Speicherkondensator mit dem ferroelektrischen Dielektrikum in einem innerhalb der ohnehin vorhandenen Kontaktmetallisierungsschicht für den zweiten Elektrodenanschluß des Auswahltransistors ausgebildeten Grabens angeordnet, wobei die Tiefe des Grabens der Schichtdicke der Kontaktmetallisierungsschicht entspricht.

Dem Konzept des erfindungsgemäßen Verfahrens liegt hierbei zunächst die Erkenntnis zugrunde, eine Halbleiter-Speichervorrichtung bzw. einen Prozeßablauf zur Herstellung der Halbleiter-Speichervorrichtung anzugeben, bei dem die ferroelektrischen Materialien in den Prozeßablauf zur Herstellung der Halbleiter-Speichervorrichtung mit Erfolg eingebunden werden können, und zwar dadurch, daß erst nach der Fertigung der vollständig ausgebildeten Auswahltransistoren samt vollständiger Metallisierung einschließlich aller dem Auswahltransistor zugeordneten Elektroden das dielektrische Material aufgebracht und zur Durchführung der notwendigen Kristallisation einer Wärmebehandlung unterzogen wird.

Das erfindungsgemäße Verfahren ermöglicht die Herstellung einer FRAM-Speichervorrichtung, deren Flächenbedarf ebenso gering ist wie bei einer RAM-Zelle, und zwar vermittels einer in bestehende Prozeßabläufe integrierbaren Prozeßschrittfolge. Hierbei kann die Schichtdicke des ferroelektrischen Dielektrikums vorzugsweise im Nanometerbereich exakt eingestellt werden.

Dem Prinzip der Erfindung folgend sieht das Verfahren zur Herstellung einer Halbleiter-Speichervorrichtung mit einem Speicherkondensator mit einem ferroelektrischen Dielektrikum nach Fertigstellung des Auswahltransistors folgende Schritte vor:
ganzflächiges Auftragen einer isolierenden Deckschicht, Ausbilden einer Kontaktmetallisierungsschicht zu dem zweiten Elektrodenanschluß des Auswahltransistors,
Ätzen eines bis zu der isolierenden Deckschicht reichenden Grabens innerhalb der Kontaktmetallisierungsschicht,
zu den Seitenwänden des Grabens konformes Abscheiden einer elektrisch leitenden Schicht für die zweite Kondensatorelektrode innerhalb des Grabens,
konformes Abscheiden einer als Platzhalter für das ferroelektrische Dielektrikum dienenden Hilfsschicht innerhalb des Grabens auf die elektrisch leitende Schicht für die zweite Kondensatorelektrode,
konformes Abscheiden einer elektrisch leitenden Schicht für die erste Kondensatorelektrode innerhalb des Grabens auf die Hilfsschicht,
wenigstens teilweises Entfernen der Hilfsschicht und dadurch Freilegen einer Hohlschicht zwischen den beiden elektrisch leitenden Schichten für die erste und die zweite Kondensatorelektrode,
Abscheiden des ferroelektrischen Dielektrikums in die freigelegte Hohlschicht zwischen den beiden elektrisch leitenden Schichten für die erste und die zweite Kondensatorelektrode.

In bevorzugter Weise wird der Schritt des Abscheidens der das ferroelektrische Dielektrikum aufweisenden dielektrischen Schicht vermittels Aufschleudern durchgeführt.

Bei einem insbesondere bevorzugten Prozeßablauf zeichnet sich das erfindungsgemäße Verfahren durch die folgenden weiteren Verfahrensschritte aus:
Rückätzen der zur Innenkontur des Grabens konform abgeschiedenen elektrisch leitenden Schicht für die zweite Kondensatorelektrode zumindest soweit, daß der außerhalb des Grabens planar abgeschiedene Teil der elektrisch leitenden Schicht für die zweite Kondensatorelektrode entfernt wird. Auf diese Weise wird die Gefahr eines elektrischen Kurzschlusses der beiden Kondensatorelektroden vermindert.

Bei einer insbesondere bevorzugten Ausgestaltung der Halbleiter-Speichervorrichtung bzw. dem Verfahren gemäß der Erfindung stellt das ferroelektrische Dielektrikum ein ferroelektrisches Gel dar, welches insbesondere eine Blei-Zirkonium-Titanat- (PZT) und/oder eine Strontium-Tantalat-Verbindung aufweist.

Des weiteren weist das Material der Schicht für die erste und/oder zweite Kondensatorelektrode vorzugsweise Titan und/oder Platin auf, wobei die Schicht für die erste und/oder zweite Kondensatorelektrode auch als Mehrfachschicht ausgebildet sein kann, und zwar vorzugsweise mit einer Schichtenfolge Titan/Titannitrid/Platin oder Titan/Titannitrid/Wolfram.

Die Erfindung ist in der nachfolgenden Beschreibung anhand eines in der Zeichnung dargestellten Ausführungsbeispieles im einzelnen beschrieben.

In der Zeichnung zeigt
Figur 1 ein Prinzipschaltbild einer erfindungsgemäßen Halbleitervorrichtung mit einer FRAM-Zelle,
Figur 2 bis Figur 4 aufeinanderfolgende Verfahrensschritte der Herstellung der erfindungsgemäßen Halbleiter-Speichervorrichtung.

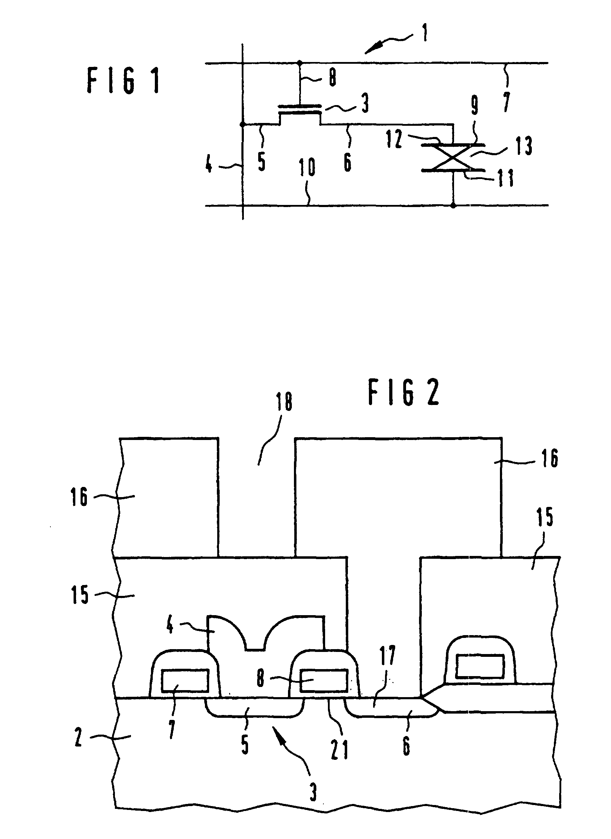

Eine erfindungsgemäße Halbleiter-Speichervorrichtung mit einer FRAM-Zelle 1 gemäß dem Ersatzschaltbild nach Fig. 1 besitzt einen auf einem Halbleiter-Substrat 2 ausgebildeten Auswahltransistor 3 vorzugsweise vom MOS-Typ mit einem an eine aus Wolfram oder Polyzid hergestellte Bitleitung 4 angeschlossenen ersten Elektrodenanschluß 5 (Source), einem zweiten Elektrodenanschluß 6 (Drain) und einen an eine aus n⁺-Poly-Si oder Polyzid hergestellte Wortleitung 7 angeschlossenen Gateanschluß 8, sowie einen Speicherkondensator 9 mit einer mit einer gemeinsamen Leiterschicht 10 (Feldplatte) verbundenen ersten Kondensatorelektrode 11, einer mit dem zweiten Elektrodenanschluß 6 des Auswahltransistors 3 verbundenen zweiten Kondensatorelektrode 12 und einem zwischen die erste und zweite Kondensatorelektrode eingebrachten ferroelektrischen Dielektrikum 13.

Ausgangspunkt des in den Fig. 2 bis 4 dargestellten Ausführungsbeispieles des erfindungsgemäßen Verfahrens zur Herstellung der Halbleiter-Speichervorrichtung ist die in Fig. 2 vermittels an sich aus dem DRAM-Prozeß bekannter Verfahrensschritte bis einschließlich der Fertigung der Bitleitung 4 dargestellte Anordnung, bei der ganzflächig eine planarisierte isolierende Deckschicht 15, beispielsweise ein BPSG-Flow-Glas abgeschieden, sowie eine selbstjustierte (überlappende) Kontaktmetallisierungsschicht 16 für den Anschluß des n⁺-dotierten Drainbereiches 17 (zweiter Elektrodenanschluß 6) des Auswahltransistors 3 ausgebildet wird. Die Kontaktmetallisierungsschicht 16 wird hierbei vorzugsweise als eine n⁺-Poly-Si-Schicht mit einer Dicke von etwa 0,7 µm konform abgeschieden.

Hieran anschließend wird in die Kontaktmetallisierungsschicht 16 vermittels einer anisotropen Ätzung ein gegenüber der Ebene 21 der Substratoberfläche aufragend ausgebildeter Graben 18, der unmittelbar oberhalb des Bereiches des Auswahltransistors 3 angeordnet und bis zur BPSG-Schicht 15 reicht, ausgebildet.

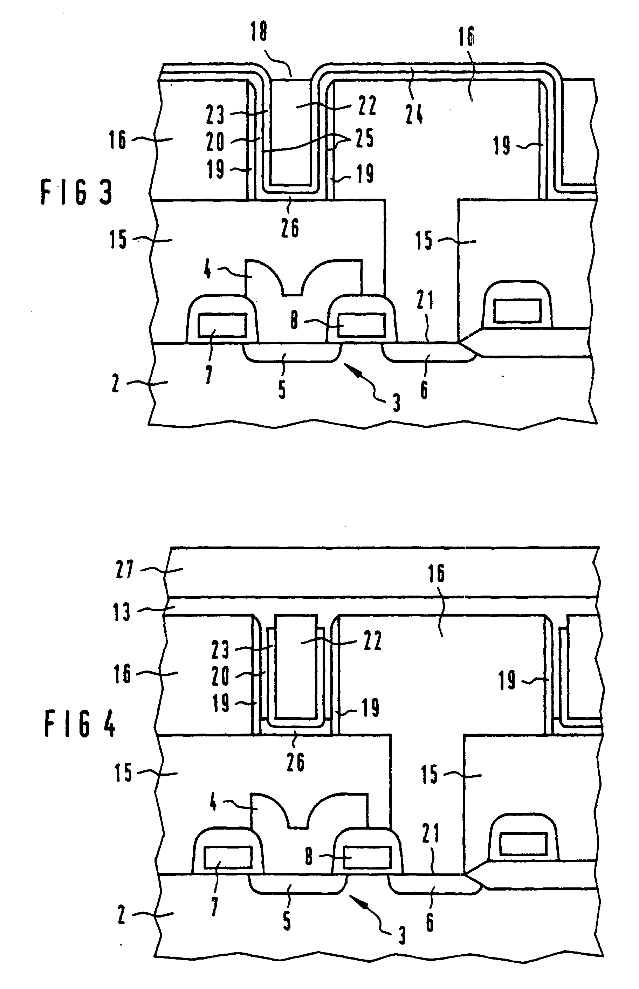

Daran anschließend wird gemäß Fig. 3 an den senkrechten Seitenwänden des Grabens 18 eine elektrisch leitende Schicht 19, d.h. ein aus Metall bestehender Abstandhalter ("Spacer") mittels konformer Abscheidung und anschließender anisotroper Rückätzung der elektrisch leitenden Schicht 19 erzeugt. Der Abstandhalter (Spacer) weist vorzugsweise eine Schichtenfolge Ti/TiN/Pt oder Ti/TiN/W auf.

Auf die somit entstehende Anordnung wird gemäß Fig. 3 eine als Platzhalter für das ferroelektrische Dielektrikum dienende Hilfsschicht 20 aus SiO₂ innerhalb des Grabens 18 auf die elektrisch leitende Schicht 19 konform abgeschieden, wobei die Dicke der SiO₂-Hilfsschicht 20 der späteren ferroelektrischen Schicht entspricht. Auf die SiO₂-Hilfsschicht 20 wird zur Erzeugung einer gemeinsamen Kondensatorplatte 10 eine vorzugsweise aus einem hochtemperaturstabilen Metall wie beispielsweise Platin oder Wolfram bestehende elektrisch leitende Schicht 23 konform abgeschieden. Der verbleibende Hohlraum in dem Graben 18 wird durch ein geeignetes Füllmaterial 22 aufgefüllt, wobei das beispielsweise aus Poly-Si bestehende Füllmaterial 22 konform abgeschieden und vorzugsweise anisotrop rückgeätzt wird. Auf diese Weise ergibt sich die in Fig. 3 dargestellte Anordnung.

Bei einem darauffolgenden Schritt wird die aus Platin oder Wolfram bestehende elektrisch leitende Schicht 23 wenigstens soweit zurückgeätzt, daß der auf den horizontalen Bereichen angeordnete Teil 24 der elektrisch leitenden Schicht 23 entfernt wird.

Nach Durchführung einer Wärmebehandlung und dadurch Ausheilen aller vorherigen Prozeßschritte wird das als Platzhalter für das ferroelektrische Dielektrikum dienende Material der Hilfsschicht 20 vorzugsweise naßchemisch, beispielsweis vermittels verdünnter Flußsäure freigeätzt, und zwar wenigstens so weit, daß zwischen den beiden Schichten 19 und 23 für die Kondensatorelektroden 11 und 12 eine gegenüber der Ebene 21 der Substratoberfläche im wesentlichen annähernd senkrecht ausgerichtete Hohlschicht 25 gebildet wird, in welche daran anschließend ein dünner Film eines ferroelektrischen Gels vorzugsweise vermittels Schleuderbeschichtung (Spin-Coating) aufgetragen wird. Hierbei werden die Hohlräume zwischen den beiden Kondensatorplatten 19 und 23 mit dem ferroelektrischen Gel aufgefüllt. Zur Kristallbildung des ferroelektrischen Dielektrikums wird dieses einem Wärmebehandlungsschritt unterzogen. Ein bei der naßchemischen Ätzung des Materials der Hilfsschicht 20 stehengelassener Boden 26 dient zur mechanischen Abstützung der koaxial innerhalb des Grabens 18 angeordneten ersten Kondensatorelektrode 23.

Daran anschließend wird gemäß Fig. 4 ganzflächig eine Passivierungsschicht 27, vorzugsweise aus SiO₂ abgeschieden. Hieran können sich weitere Prozeßschritte in an sich bekannter Weise anschließen, beispielsweise für die Metallisierung.

## Patentansprüche

1. Verfahren zur Herstellung einer auf einem Halbleiter-Substrat gebildeten Halbleiter-Speichervorrichtung mit einem Kondensator (9) mit einem Dielektrikum (13) sowie einer ersten (11) und einer zweiten Kondensatorelektrode (12), mit den Schritten:
a) ganzflächiges Aufbringen einer isolierenden Deckschicht (15) auf das Halbleitersubstrat,
b) Ausbilden eines Grabens (18) in einer auf die isolierende Deckschicht (15) aufgetragenen Kontaktmetallisierungsschicht (16), wobei der Graben (18) zumindest bis zur isolierenden Deckschicht (15) reicht,
c) zu den Seitenwänden des Grabens (18) wenigstens bereichsweises konformes Abscheiden einer elektrisch leitenden Schicht (19) für die zweite Kondensatorelektrode (12) innerhalb des Grabens (18),
d) anisotropes Rückätzen der elektrisch leitenden Schicht (19) unter Bildung von Spacern an den Seitenwänden des Grabens (18),
e) konformes Abscheiden einer als Platzhalter für das Dielektrikum (13) dienenden isolierenden Hilfsschicht (20) innerhalb des Grabens (18) auf die elektrisch leitende Schicht (19) für die zweite Kondensatorelektrode (12),
f) konformes Abscheiden einer elektrisch leitenden Schicht (23) für die erste Kondensatorelektrode (11) innerhalb des Grabens (18) auf die Hilfsschicht (20),
g) teilweises Entfernen der Hilfsschicht (20) und dadurch Freilegen einer Hohlschicht (25) in wenigstens einem Teilbereich zwischen den beiden elektrisch leitenden Schichten (19, 23) für die erste und die zweite Kondensatorelektrode,
h) Abscheiden des Dielektrikums (13) in die freigelegte Hohlschicht (25) zwischen den beiden elektrisch leitenden Schichten (19, 23) für die erste und die zweite Kondensatorelektrode.

2. Verfahren zur Herstellung eines Kondensators nach Anspruch 1, **dadurch gekennzeichnet, daß**
der Schritt des Abscheidens des Dielektrikums (13) vermittels Aufschleudern durchgeführt wird.

3. Verfahren zur Herstellung eines Kondensators nach Anspruch 1 oder 2, **dadurch gekennzeichnet, daß**
das Dielektrikum (13) ein ferroelektrisches Gel darstellt.

4. Verfahren zur Herstellung eines Kondensators nach Anspruch 3, **dadurch gekennzeichnet, daß**
das ferroelektrische Gel eine Blei-Zirkonium-Titanat- (PZT) oder eine Strontium-Tantalat-Verbindung aufweist.

5. Verfahren zur Herstellung eines Kondensators nach einem der Ansprüche 1 bis 4, **dadurch gekennzeichnet, daß**
die als Platzhalter für das Dielektrikum (13) dienende Hilfsschicht (20) SiO₂ aufweist.

6. Verfahren zur Herstellung eines Kondensators nach einem der Ansprüche 1 bis 5, **dadurch gekennzeichnet, daß**
die elektrisch leitende Schicht (19) für die zweite Kondensatorelektrode (12) aus wenigstens einem Metall besteht.

7. Verfahren zur Herstellung eines Kondensators nach Anspruch 6, **dadurch gekennzeichnet, daß**
die elektrisch leitende Schicht (19) für die zweite Kondensatorelektrode (12) wenigstens ein Metall aus der Gruppe Titan, Platin und Wolfram enthält.

8. Halbleiter-Speichervorrichtung mit einer Vielzahl von auf einem Halbleitersubstrat angeordneten Speicherzellen (1), von denen jede einen in einem Halbleitersubstrat angeordneten und jeweils einen Gateanschluß (8) sowie einen ersten (5) und einen zweiten Elektrodenanschluß (6) aufweisenden Auswahltransistor (3) und einen dem Auswahltransistor (3) zugeordneten und vermittels diesem ansteuerbaren Speicherkondensator (9) mit einem Dielektrikum (13) sowie einer ersten (11) und einer zweiten Kondensatorelektrode (12) aufweist, wobei jeder Gateanschluß (8) des Auswahltransistors (3) mit einer Wortleitung (7) der Halbleiter-Speichervorrichtung, jeder erste Elektrodenanschluß (5) des Auswahltransistors (3) mit einer Bitleitung (4), und jede erste Kondensatorelektrode (11) des Speicherkondensators (9) mit einer gemeinsamen Leiterschicht (10) aus elektrisch leitendem Material verbunden ist, wobei der dem Auswahltransistor (3) zugeordnete Speicherkondensator (9) mit dem Dielektrikum (13) eine gegenüber der Ebene (21) der Substratoberfläche aufragende Anordnung besitzt,
**dadurch gekennzeichnet, daß**
der Speicherkondensator (9) mit dem Dielektrikum (13) in einem innerhalb einer Kontaktmetallisierungsschicht (16) für den zweiten Elektrodenanschluß (6) des Auswahltransistors (3) ausgebildeten Grabens (18) angeordnet ist, wobei der Graben (18) zumindest bis zu einer zwischen dem Substrat und der Kontaktmetallisierungsschicht (16) sitzenden isolierenden Deckschicht (15) reicht.

9. Halbleiter-Speichervorrichtung nach Anspruch 8, **dadurch gekennzeichnet, daß**
die gegenüber der Ebene (21) der Substratoberfläche aufragende Anordnung des Speicherkondensators (9) im wesentlichen zylindersymmetrisch ausgebildet ist mit einer wenigstens annähernd senkrecht zur Ebene (21) der Substratoberfläche verlaufenden Zylindermittenachse.

10. Halbleiter-Speichervorrichtung nach Anspruch 8 oder 9,
**dadurch gekennzeichnet, daß**
die zweite Kondensatorelektrode (12) des innerhalb des Grabens (18) ausgebildeten Speicherkondensators (9) als konform auf den senkrechten Seitenwänden des Grabens (18) abgeschiedener Spacer ausgebildet ist.

11. Halbleiter-Speichervorrichtung nach einem der Ansprüche 8 bis 10, **dadurch gekennzeichnet, daß**
die erste Kondensatorelektrode (11) des Speicherkondensators (9) einen innerhalb des Grabens (18) ausgebildeten, koaxial zur Längserstreckung des Grabens (18) und gegenüberliegend zur zweiten Kondensatorelektrode (12) verlaufenden Elektrodenabschnitt aufweist, und das Dielektrikuitt (13) zumindest zwischen dem Elektrodenabschnitt der ersten Kondensatorelektrode (12) und der zweiten Kondensatorelektrode angeordnet ist.

12. Halbleiter-Speichervorrichtung nach einem der Ansprüche 8 bis 11, **dadurch gekennzeichnet, daß**
die erste Kondensatorelektrode (11) des Speicherkondensators (9) becherförmig innerhalb der zweiten Kondensatorelektrode (12) ausgebildet ist, wobei im Bodenbereich der beiden Kondensatorelektroden (11, 12) eine isolierende Hilfsschicht (20, 26) angeordnet ist.

13. Halbleiter-Speichervorrichtung nach Anspruch 12, **dadurch gekennzeichnet, daß**
die becherförmige erste Kondensatorelektrode (11) mit einem hochtemperaturstabilen Material aufgefüllt ist, welches insbesondere Wolfram oder eine Wolframverbindung aufweist.

14. Halbleiter-Speichervorrichtung nach einem der Ansprüche 8 bis 13, **dadurch gekennzeichnet, daß**
das Dielektrikum (13) aus einem ferroelektrischen Material besteht.

15. Halbleiter-Speichervorrichtung nach Anspruch 14, **dadurch gekennzeichnet, daß**
das ferroelektrische Dielektrikum (13) ein ferroelektrisches Gel darstellt, welches insbesondere eine Blei-Zirkonium-Titanat- (PZT) oder eine Strontium-Tantalat-Verbindung aufweist.

16. Halbleiter-Speichervorrichtung nach einem der Ansprüche 8 bis 15, **dadurch gekennzeichnet, daß**
das Material der elektrisch leitenden Schichten (19, 23) für die erste oder zweite Kondensatorelektrode (11, 12) Titan oder Platin aufweist.

17. Halbleiter-Speichervorrichtung nach Anspruch 16, **dadurch gekennzeichnet, daß**
die elektrisch leitenden Schichten (19, 23) für die erste oder zweite Kondensatorelektrode (11, 12) als Mehrfachschicht ausgebildet sind.

18. Halbleiter-Speichervorrichtung nach Anspruch 17, **dadurch gekennzeichnet, daß**
die Mehrfachschicht für die erste oder zweite Kondensatorelektrode (11, 12) die Schichtenfolge Titan/Titannitrid/Platin oder Titan/Titannitrid/Wolfram aufweist.

19. Halbleiter-Speichervorrichtung nach einem der Ansprüche 8 bis 18, **dadurch gekennzeichnet, daß**
die isolierende Deckschicht (15) aus einem BPSG Flow-Glas-Material hergestellt ist.

## Claims

1. Method for fabricating a semiconductor memory device formed on a semiconductor substrate, having a capacitor (9) having a dielectric (13) and also a first (11) and a second capacitor electrode (12), having the steps of:
a) applying an insulating covering layer (15) to the whole area of the semiconductor substrate,
b) forming a trench (18) in a contact metallization layer (16) applied to the insulating covering layer (15), the trench (18) reaching at least as far as the insulating covering layer (15),
c) depositing conformally, at least in regions with respect to the sidewalls of the trench (18), an electrically conductive layer (19) for the second capacitor electrode (12) within the trench (18),
d) anisotropically etching back the electrically conductive layer (19) to form spacers on the sidewalls of the trench (18),
e) conformally depositing an insulating auxiliary layer (20), which serves as a spacer for the dielectric (13), within the trench (18) onto the electrically conductive layer (19) for the second capacitor electrode (12),
f) conformally depositing an electrically conductive layer (23) for the first capacitor electrode (11) within the trench (18) onto the auxiliary layer (20),
g) partially removing the auxiliary layer (20) and thereby uncovering a hollow layer (25) in at least one partial region between the two electrically conductive layers (19, 23) for the first and second capacitor electrodes,
h) depositing the dielectric (13) into the uncovered hollow layer (25) between the two electrically conductive layers (19, 23) for the first and second capacitor electrodes.

2. Method for fabricating a capacitor according to Claim 1, **characterized in that**
the step of depositing the dielectric (13) is carried out by means of spinning on.

3. Method for fabricating a capacitor according to Claim 1 or 2, **characterized in that**
the dielectric (13) constitutes a ferroelectric gel.

4. Method for fabricating a capacitor according to Claim 3, **characterized in that**
the ferroelectric gel has a lead zirconium titanate ((PZT) or a strontium tantalate compound.

5. Method for fabricating a capacitor according to one of Claims 1 to 4, **characterized in that**
the auxiliary layer (20) serving as a spacer for the dielectric (13) has SiO₂.

6. Method for fabricating a capacitor according to one of Claims 1 to 5, **characterized in that**
the electrically conductive layer (19) for the second capacitor electrode (12) comprises at least one metal.

7. Method for fabricating a capacitor according to Claim 6, **characterized in that**
the electrically conductive layer (19) for the second capacitor electrode (12) contains at least one metal from the group titanium, platinum and tungsten.

8. Semiconductor memory device having a multiplicity of memory cells (1) arranged on a semiconductor substrate, each of which memory cells has a selection transistor (3), which is arranged in a semiconductor substrate and in each case has a gate terminal (8) and also a first (5) and a second electrode terminal (6), and a storage capacitor (9), which is assigned to the selection transistor (3) and can be driven by means of the latter and has a dielectric (13) and also a first (11) and a second capacitor electrode (12), each gate terminal (8) of the selection transistor (3) being connected to a word line (7) of the semiconductor memory device, each first electrode terminal (5) of the selection transistor (3) being connected to a bit line (4) and each first capacitor electrode (11) of the storage capacitor (9) being connected to a common conductor layer (10) made of electrically conductive material, the storage capacitor (9) - assigned to the selection transistor (3) - with the dielectric (13) having an arrangement projecting relative to the plane (21) of the substrate surface,
**characterized in that**
the storage capacitor (9) with the dielectric (13) is arranged in a trench (18) formed within a contact metallization layer (16) for the second electrode terminal (6) of the selection transistor (3), the trench (18) reaching at least as far as an insulating covering layer (15) situated between the substrate and the contact metallization layer (16).

9. Semiconductor memory device according to Claim 8,
**characterized in that**
the arrangement of the storage capacitor (9) projecting relative to the plane (21) of the substrate surface is formed such that it is essentially cylinder-symmetrical, with a cylinder centre axis running at least approximately perpendicularly to the plane (21) of the substrate surface.

10. Semiconductor memory device according to Claim 8 or 9, **characterized in that**
the second capacitor electrode (12) of the storage capacitor (9) formed within the trench (18) is formed as a spacer deposited conformally on the perpendicular sidewalls of the trench (18).

11. Semiconductor memory device according to one of Claims 8 to 10, **characterized in that [sic]**
the first capacitor electrode (11) of the storage capacitor (9) has an electrode section which is formed within the trench (18) and runs coaxially with respect to the longitudinal extent of the trench (18) and opposite to the second capacitor electrode (12), and the dielectric (13) is arranged at least between the electrode section of the first capacitor electrode (12) and the second capacitor electrode.

12. Semiconductor memory device according to one of Claims 8 to 11, **characterized in that**
the first capacitor electrode (11) of the storage capacitor (9) is formed in a cup-shaped manner within the second capacitor electrode (12), an insulating auxiliary layer (20, 26) being arranged in the bottom region of the two capacitor electrodes (11, 12).

13. Semiconductor memory device according to Claim 12,
**characterized in that**
the cup-shaped first capacitor electrode (11) is filled with a material which is stable at high temperatures and has, in particular, tungsten or a tungsten compound.

14. Semiconductor memory device according to one of Claims 8 to 13, **characterized in that**
the dielectric (13) comprises a ferroelectric material.

15. Semiconductor memory device according to Claim 14,
**characterized in that**
the ferroelectric dielectric (13) constitutes a ferroelectric gel which has, in particular, lead zirconium titanate (PZT) or a strontium tantalate compound.

16. Semiconductor memory device according to one of Claims 8 to 15, **characterized in that**
the material of the electrically conductive layers (19, 23) for the first or second capacitor electrode (11, 12) has titanium or platinum.

17. Semiconductor memory device according to Claim 16,
**characterized in that**
the electrically conductive layers (19, 23) for the first or second capacitor electrode (11, 12) are formed as a multilayer.

18. Semiconductor memory device according to Claim 17,
**characterized in that**
the multilayer for the first or second capacitor electrode (11, 12) has the layer sequence titanium/titanium nitride/platinum or titanium/titanium nitride/tungsten.

19. Semiconductor memory device according to one of Claims 8 to 18, **characterized in that**
the insulating covering layer (15) is fabricated from a BPSG flow glass material.

## Revendications

1. Procédé de fabrication d'un dispositif de mémoire à semiconducteur formé sur un substrat semiconducteur, comprenant un condensateur (9), un diélectrique (13), ainsi qu'une première (11) et deuxième (12) électrodes de condensateur, par les stades :
a) dépôt sur toute la surface d'une couche (15) isolante de finition sur le substrat semiconducteur,
b) constitution d'un sillon (18) dans une couche (16) de métallisation de contact déposée sur la couche (15) isolante de finition, le sillon (18) allant au moins jusqu'à la couche (15) isolante de finition,
c) dépôt conforme au moins par zone sur les parois latérales du sillon (18) d'une couche (19) conductrice de l'électricité pour la deuxième électrode (12) de condensateur à l'intérieur du sillon (18),
d) attaque anisotrope en retrait de la couche (19) conductrice de l'électricité avec formation d'espaceurs sur les parois latérales du sillon (18),
e) dépôt conforme à l'intérieur du sillon (18) sur la couche (19) conductrice de l'électricité pour la deuxième électrode (12) de condensateur d'une couche (20) isolante auxiliaire servant d'emplacement pour le diélectrique (13),
f) dépôt conforme d'une couche (23) conductrice de l'électricité pour la première électrode (11) de condensateur dans le sillon (18) sur la couche (20) auxiliaire,
g) enlèvement partiel de la couche (20) auxiliaire et mise à nu ainsi d'une couche (25) creuse dans au moins une sous-région comprise entre les deux couches (19, 23) conductrices de l'électricité pour la première et la deuxième électrodes de condensateur,
h) dépôt du diélectrique (13) dans la couche (25) creuse mise à nu entre les deux couches (19, 23) conductrices de l'électricité pour la première et la deuxième électrodes de condensateur.

2. Procédé de fabrication d'un condensateur suivant la revendication 1, **caractérisé en ce que** le stade de dépôt du diélectrique (13) est effectué au moyen d'une centrifugation.

3. Procédé de fabrication d'un condensateur suivant la revendication 1 ou 2, **caractérisé en ce que** le diélectrique (13) est un gel ferroélectrique.

4. Procédé de fabrication d'un condensateur suivant la revendication 3, **caractérisé en ce que** le gel ferroélectrique comprend un composé au titanate de plomb et de zirconium (PZT) ou un composé au tantalate de strontium.

5. Procédé de fabrication d'un condensateur suivant l'une des revendications 1 à 4, **caractérisé en ce que** la couche (20) auxiliaire servant d'emplacement pour le diélectrique (13) comprend du SiO₂.

6. Procédé de fabrication d'un condensateur suivant l'une des revendications 1 à 5, **caractérisé en ce que** la couche (19) conductrice de l'électricité pour la deuxième électrode (12) de condensateur est en au moins un métal.

7. Procédé de fabrication d'un condensateur suivant la revendication 6, **caractérisé en ce que** la couche (19) conductrice de l'électricité pour la deuxième électrode (12) de condensateur contient au moins un métal du groupe du titane, du platine et du tungstène.

8. Dispositif de mémoire à semiconducteur ayant une pluralité de cellules (1) de mémoire disposées sur un substrat semiconducteur, dont chacune comporte un transistor (3) de sélection disposé sur un substrat semiconducteur et ayant respectivement une borne (8) de grille, ainsi qu'une première (5) et une deuxième (6) bornes d'électrode et un condensateur (9) de mémoire associé à ce transistor (3) de sélection et pouvant être commandé au moyen de celui-ci, ainsi qu'une première (11) et une deuxième (12) électrodes de condensateur et un condensateur (9) de mémoire associé à ce transistor (3) de sélection et pouvant être commandé au moyen de celui-ci, comportant un diélectrique (13) ainsi qu'une première (11) et une deuxième (12) électrodes de condensateur, chaque borne (8) de grille du transistor (3) de sélection étant reliée à une ligne (7) de mot du dispositif de mémoire à semiconducteur, chaque première borne (5) d'électrode du transistor (3) de sélection étant reliée à une ligne (4) de bit et chaque première électrode (11) du condensateur (9) de mémoire est reliée à une couche (10) commune conductrice en un matériau conducteur de l'électricité, le condensateur (9) de mémoire associé au transistor (3) de sélection ayant, avec le diélectrique (13), un agencement par rapport au plan (21) de la surface du substrat, **caractérisé en ce que** le condensateur (9) de mémoire est disposé avec le diélectrique (13) dans un sillon (18) au sein d'une couche (16) de métallisation de contact pour la deuxième borne (6) d'électrode du transistor (3) de sélection, le sillon (18) allant au moins jusqu'à une couche (15) isolante de finition se trouvant entre le substrat et la couche (16) de métallisation de contact.

9. Dispositif de mémoire à semiconducteur suivant la revendication 8, **caractérisé en ce que** l'agencement en saillie par rapport au plan (21) du substrat du condensateur (9) de mémoire est essentiellement de symétrie cylindrique en ayant un axe médian de cylindre s'étendant au moins approximativement perpendiculairement au plan (21) de surface du substrat.

10. Dispositif de mémoire à semiconducteur suivant la revendication 8 ou 9, **caractérisé en ce que** la deuxième électrode (12) du condensateur (9) de mémoire constitué au sein du sillon (18) est constituée sous la forme d'espaceurs déposés de manière conforme sur les parois latérales verticales du sillon (18).

11. Dispositif de mémoire à semiconducteur suivant l'une des revendications 8 à 10, **caractérisé en ce que** la première électrode (11) du condensateur (9) de mémoire comporte un tronçon d'électrode constitué au sein du sillon (18), s'étendant coaxialement à la direction longitudinale du sillon (18) et opposé à la deuxième électrode (12) de condensateur, et **en ce que** le diélectrique (13) est disposé au moins entre le tronçon d'électrode de la première électrode (12) de condensateur et la deuxième électrode de condensateur.

12. Dispositif de mémoire à semiconducteur suivant l'une des revendications 8 à 11, **caractérisé en ce que** la première électrode (11) du condensateur (9) de mémoire est constituée sous la forme d'un godet à l'intérieur de la deuxième électrode (12) de condensateur, une couche (20,26) isolante auxiliaire étant disposée dans la région de fond des deux électrodes (11, 12) de condensateur.

13. Dispositif de mémoire à semiconducteur suivant la revendication 12, **caractérisé en ce que** la première électrode (11) de condensateur en forme de godet est emplie d'une matière stable à haute température qui comporte notamment du tungstène ou un composé du tungstène.

14. Dispositif de mémoire à semiconducteur suivant l'une des revendications 8 à 13, **caractérisé en ce que** le diélectrique (13) est en un matériau ferroélectrique.

15. Dispositif de mémoire à semiconducteur suivant la revendication 14, **caractérisé en ce que** le diélectrique (13) ferroélectrique est un gel ferroélectrique qui comprend notamment un composé au titanate de plomb et de zirconium (PZT) ou un composé au tantalate de strontium.

16. Dispositif de mémoire à semiconducteur suivant l'une des revendications 8 à 15, **caractérisé en ce que** la matière des couches (19, 23) conductrices de l'électricité pour la première ou la deuxième électrode (11, 12) de condensateur comprend du titane ou du platine.

17. Dispositif de mémoire à semiconducteur suivant la revendication 16, **caractérisé en ce que** les couches (19, 23) conductrices de l'électricité pour la première et la deuxième électrode (11, 12) de condensateur sont constituées sous la forme d'une couche stratifiée.

18. Dispositif de mémoire à semiconducteur suivant la revendication 17, **caractérisé en ce que** la couche stratifiée pour la première ou la deuxième électrode (11, 12) de condensateur comporte la succession de couches titane/nitrure de titane/platine ou titane/nitrure de titane/tungstène.

19. Dispositif de mémoire à semiconducteur suivant l'une des revendications 8 à 18, **caractérisé en ce que** la couche (15) isolante de finition est en une matière en verre ou au borophosphosilicate Flow-Glas.
